# EUROPÄISCHE PATENTSCHRIFT

(11) **EP 1 740 421 B1**
(45) Veröffentlichungstag und Bekanntmachung des Hinweises auf die Patenterteilung: **12.12.2007**
(21) Anmeldenummer: 05739632.7
(22) Anmeldetag: 05.04.2005
(51) Int. Cl.: B60R 25/00, G07C 9/00

(54) **VORRICHTUNG ZUM BETÄTIGEN VON ELEKTRISCHEN ODER ELEKTROMECHANISCHEN ZUGANGS- BZW ZUGRIFFSYSTEMEN AN ODER IN EINEM FAHRZEUG**
DEVICE FOR OPERATING ELECTRICAL OR ELECTROMECHANICAL ENTRY OR ACCESS SYSTEMS ON OR IN A VEHICLE
DISPOSITIF POUR ACTIONNER DES SYSTEMES D'ACCES ELECTRIQUES OU ELECTROMECANIQUES SUR OU DANS UN VEHICULE

(30) Priorität: 30.04.2004 DE 102004021505
(43) Veröffentlichungstag der Anmeldung: 10.01.2007
(73) Patentinhaber: Huf Hülsbeck & Fürst GmbH & Co. KG, 42551 Velbert (DE)
(72) Erfinder: STEEGMANN, Bernd, 42579 Heiligenhaus (DE); WITTE, Martin, 48683 Ahaus (DE)
(74) Vertreter: Mentzel, Norbert
(86) Internationale Anmeldenummer: PCT/EP2005/003554
(87) Internationale Veröffentlichungsnummer: WO 2005/108175

(56) Entgegenhaltungen:
- EP-A- 1 187 075
- EP-A- 1 339 025
- DE-A1- 10 206 968

## Beschreibung

Die Erfindung richtet sich auf eine Vorrichtung der im Oberbegriff des Anspruches 1 angegebenen Art. Der Sensor der Vorrichtung spricht auf eine Annäherung oder Berührung an.

Aus der DE 196 17 038 C2 ist es bekannt, in einer Schließeinrichtung eines Fahrzeugs einen kapazitiven Sensor vorzusehen, der nur dann anspricht, wenn sich eine berechtigte Person ihm nähert. Bei dieser bekannten Vorrichtung ist die berechtigte Person im Besitz eines Identifikationsgebers (ID-Geber), dem ein Identifikationsnehmer (ID-Nehmer) im Fahrzeug zugeordnet ist. Bei Annäherung der Hand an den Sensor wird eine Änderung der Kapazität, die vom Sensor festgestellt wird. Sofern es sich dabei um eine berechtigte Person handelt, beginnt eine Datenkommunikation zwischen dem ID-Geber und dem ID-Nehmer. Die empfangenen Ist-Daten werden mit in einem Speicher enthaltenen Soll-Daten verglichen. Liegt ein erfolgreicher Vergleich vor, so wird die Betätigung der Schließeinrichtung wirksam gesetzt und zwar noch bevor die eigentliche Betätigung einer Handhabe der Schließeinrichtung von der berechtigten Person ausgeführt wird. Die Person, welche die Handhabe betätigt, merkt von dieser Kommunikation und den Datenvergleichen nichts; das Öffnen und Schließen der Tür oder einer Klappe erfolgt ohne Zeitverzug.

Damit nicht unnötige, energieverbrauchende Kommunikationen erfolgen, darf ein Sensor nicht auf die Annäherung oder Berührung durch ein beliebiges Objekt ansprechen, sondern nur durch die menschliche Hand. Unerwünscht ist, wenn Betätigungen der Einrichtung durch beliebige äußere Einflüsse herbeigeführt werden, wie Regen, Schnee, Eis oder Blätter. Um dem entgegenzuwirken, hat man bei der aus DE 196 20 059 A1 bekannten Schließeinrichtung auch die Geschwindigkeit der Änderung der Kapazität ermittelt, die sich bei Annäherung oder Berührung mit einem Objekt ergibt. Man nutzt bei dieser bekannten Vorrichtung den Umstand, dass eine Kapazitätsänderung pro Zeiteinheit bei Annäherung einer menschlichen Hand an den Sensor größer ist, als durch Fehlerobjekte. Misst man die Kapazitätsänderung pro Zeiteinheit, so wird eine Betätigung der Schließeinrichtung nur dann wirksam gesetzt, wenn ein bestimmter Grenzwert der zeitlichen Kapazitätsänderung überschritten wird. Diese Methode ist aber nicht in allen Fällen anwendbar.

Aus der WO 03/095776 A1 ist eine schlüssellose Betätigungseinrichtung für Kraftfahrzeuge bekannt, die zwei oder mehr Sensoren vorsieht, um Fehlauslösungen bei der Bedienfunktion auszuschließen. Diese Sensoren lösen eine oder mehrere Bedienungsfunktionen im Fahrzeug aus. In Abhängigkeit von dem Zeitmuster der Beaufschlagung dieser mehrfachen Sensoren werden unterschiedliche Bedienfunktionen eingeleitet. Auf diese Weise soll eine Fehlauslösung der Bedienfunktion ausgeschlossen werden, wenn sich z.B. die Bedienungsperson unachtsam an das Fahrzeug anlehnt und dadurch für den Start der Datenabfrage sorgt.

Aus der DE 42 22 990 A1 ist ein Verfahren und eine Vorrichtung zur Auswertung einer Berührung bekannt, um bewegliche Teile motorisch besser erfassen zu können, z.B. Antriebe, Warentransporteinrichtungen und Zähleinrichtungen von Stückgut. Dabei findet eine Berührung von zwei Flächen an beweglichen Teilen statt, bei der durch Energieeinspeisung eine mechanische Schwingung im bewegten Teil erzeugt wird. Diese Schwingung wird dann elektronisch oder physikalisch abgetastet. Durch die Berührung des bewegten Teils mit einem weiteren Teil ergibt sich eine Beeinflussung der Amplitude und der Frequenz der Schwingung, was ausgewertet wird. Es ist nicht angegeben, ein solches oder ein abgewandeltes Verfahren dazu zu verwenden, um Vorrichtungen an oder in einem Fahrzeug freizuschalten. Eine codierte Datenübertragung findet nicht statt.

Aus der EP 1339025 ist eine Vorrichtung nach dem Oberbegriff des Anpruchs 1 bekannt.

Der Erfindung liegt die Aufgabe zugrunde, eine zuverlässige Vorrichtung der im Oberbegriff des Anspruches 1 genannten Art zu entwickeln, die eindeutig unterscheidet, ob eine Ansteuerung des Sensors durch eine menschliche Hand oder durch Fehlerobjekte erfolgt und dementsprechend die Betätigung der Einrichtung frei schaltet oder nicht frei schaltet. Dies wird erfindungsgemäß durch die im Anspruch 1 genannten Maßnahmen erreicht, denen folgende besondere Bedeutung zukommt.

Die Erfindung verfolgt den zeitlichen Verlauf der Signale, die bei Annäherung oder Berührung an einem Sensor anfallen. Die Erfindung hat nämlich erkannt, dass der von einer menschlichen Hand am Sensor erzeugte Signal-Verlauf sich erheblich von dem zeitlichen Ablauf jener anderen Signale unterscheidet, die von Fehlerobjekten, wie Blättern, Regen, Schnee od. dgl. erzeugt werden, wenn sie sich dem Sensor nähern bzw. ihn berühren. Die erfindungsgemäße Vorrichtung ist lernfähig. In einer anfänglichen Einstellphase erfasst die Vorrichtung die Datensätze jener Signale und legt sie im Speicher ab, die an definierten Zeitpunkten im zeitlichen Signal-Verlauf anfallen, nachdem ein Sensor auf verschiedene Objekte angesprochen hat. Wenn eine Hand verschiedener Menschen sich dem Sensor auf unterschiedliche Weise nähert oder ihn berührt, gibt es mehrere Sätze von betätigungs-typischen Daten, die nachfolgend kurz "Gut-Daten" bezeichnet werden sollen. Alternativ oder zusätzlich könnten auch Daten jener Signale erfasst und gespeichert werden, die sich an den gleichen definierten Zeitpunkten in einem analogen Signal-Verlauf ergeben, wenn sich Fehlerobjekte dem Sensor nähern. Solche fehler-typische Datensätze sollen "Schlecht-Daten" genannt werden.

Nach dieser Einstellphase kann die eigentliche Gebrauchsphase der Vorrichtung beginnen. Wenn dann der Sensor anspricht, wird der sich dabei ergebende Ist-Datensatz ebenfalls in seinem zeitlichen Signal-Verlauf in den gleichen definierten Zeitpunkten erfasst, wie in der Einstellphase. Dann braucht dieser Ist-Datensatz vom Controller nur noch mit wenigstens einem der gespeicherten Datensätze verglichen werden, um festzustellen, ob die ermittelten Werte dem Gut-Datensatz oder ein Schlecht-Datensatz zuzuordnen sind. Dementsprechend wird die Betätigung der Einrichtung vom Controller freigeschaltet oder unwirksam gemacht. Durch die Speicherung einer Vielzahl solcher Gut- und/oder Schlecht-Datensätze erhöht sich die Intelligenz der erfindungsgemäßen Vorrichtung. Im Gebrauchsfall kann die Vorrichtung dann sehr genau unterscheiden, ob die richtigen Objekte, nämlich die menschliche Hand, oder ob Fehlerobjekte den Sensor ansprechen ließen. Aufgrund seiner Intelligenz könnte die Vorrichtung sogar unterscheiden, welche Art von Fehlerobjekten den Sensor aktiviert haben.

Man könnte die Einstellphase der Vorrichtung auch während der Gebrauchsphase weiter betreiben und damit die Intelligenz der erfindungsgemäßen Vorrichtung im Laufe der Zeit sogar noch erhöhen. Wenn der Sensor anspricht und eine tatsächliche Betätigung der Einrichtung nachfolgend nicht erfolgt, erkennt die Vorrichtung, dass es sich um ein Fehlerobjekt gehandelt hat. Dann kann die Vorrichtung den betreffenden Datensatz als ein weiteres Beispiel von "Schlecht-Daten" in seinen Speicher ablegen. Dadurch ist der Speicher gewachsen und kann bei kommenden Ereignissen die Unterscheidung zwischen Gut-Daten und Schlecht-Daten noch genauer vollziehen.

Weil der Datenvergleich einigen Zeitaufwand erfordert empfiehlt es sich, gemäß Anspruch 12, bereits mit dem Eingang der Ist-Daten die Einrichtung freischalten, sie aber noch nicht vollziehen. Erweist sich im Zuge der weiteren Auswertung der Ist-Daten, dass es sich dabei doch um einen Schlecht-Satz handelt, dann wird das Wirksamsetzen der Betätigung widerrufen und die weitere Betätigung unwirksam gesetzt. Im anderen Fall, wenn Gut-Daten festgestellt werden, dann ist die Betätigung der Einrichtung ohne Zeitverzögerung frei und kann sofort vollzogen werden. Das hat den Vorteil einer schnellen Reaktion der Einrichtung nach ihrer Betätigung.

Weitere Maßnahmen und Vorteile der Erfindung ergeben sich aus den Unteransprüchen, der nachfolgenden Beschreibung und den Zeichnungen. In den Zeichnungen ist die Erfindung in einem Ausführungsbeispiel schematisch dargestellt. Es zeigen:
- Fig. 1: einen im wesentlichen horizontalen Längsschnitt durch einen Türaußengriff eines Fahrzeugs, an welchem die erfindungsgemäße Vorrichtung verwirklicht ist, und zwar längs der in Fig. 2 mit I - I gekennzeichneten Schnittlinie und
- Fig. 2: einen vertikalen Längsschnitt durch den in Fig. 1 gezeigten Türaußengriff längs der dortigen Schnittlinie II - II.

In den nachfolgenden Figuren ist der zeitliche Signalverlauf in der Schaltung des Sensors dargestellt, wenn sich verschiedene Objekte dem Sensor nähern, und zwar die anfallende Spannung in Abhängigkeit von der Zeit. Im Einzelnen zeigen:
- Fig. 3: ein erstes Diagramm, welches bei einer kurzen Betätigung der Handhabe, des in Fig. 1 und 2 gezeigten Türaußengriffs sich ergibt,
- Fig. 4: ein analoges Diagramm, wenn Regen in Form eines Wasserschwalls auf die Handhabe des erfindungsgemäßen Türaußengriffs fällt und
- Fig. 5: ein drittes Diagramm, das am Sensor dann anfällt, wenn Wasserspritzer in den Bereich der Handhabe gelangen.

Im vorliegenden Fall liegt eine als Schließeinrichtung 10 ausgebildete elektromechanische Einrichtung bei des im Ausführungsbeispiel dargestellten erfindungsgemäßen Türaußengriffs vor. Die Schließeinrichtung 10 umfasst einen Träger 11, der im Inneren einer Tür 12 eines nicht näher gezeigten Fahrzeugs befestigt ist. Von der Tür 12 ist lediglich die Außenverkleidung 13 strichpunktiert angedeutet.

Zu der Schließeinrichtung 10 gehört noch eine Handhabe 20. Die Handhabe 20 ist mit ihrem einen Ende 21 im Träger 11 schwenkgelagert. Die Achse 14 der Schwenklagerung erstreckt sich im wesentlichen vertikal, weshalb die Handhabe 20 ein sogenannter "Ziehgriff" ist. Das andere Ende 22 der Handhabe 20 besitzt eine Verlängerung mit einem Hakenende, die einen Durchbruch 15 in der Türaußenverkleidung 13 und im Träger 11 durchsetzt. Das Hakenende der Verlängerung hintergreift ein mechanisches Eingangsglied 31 an einem in der Tür 12 befindlichen Schloss 30.

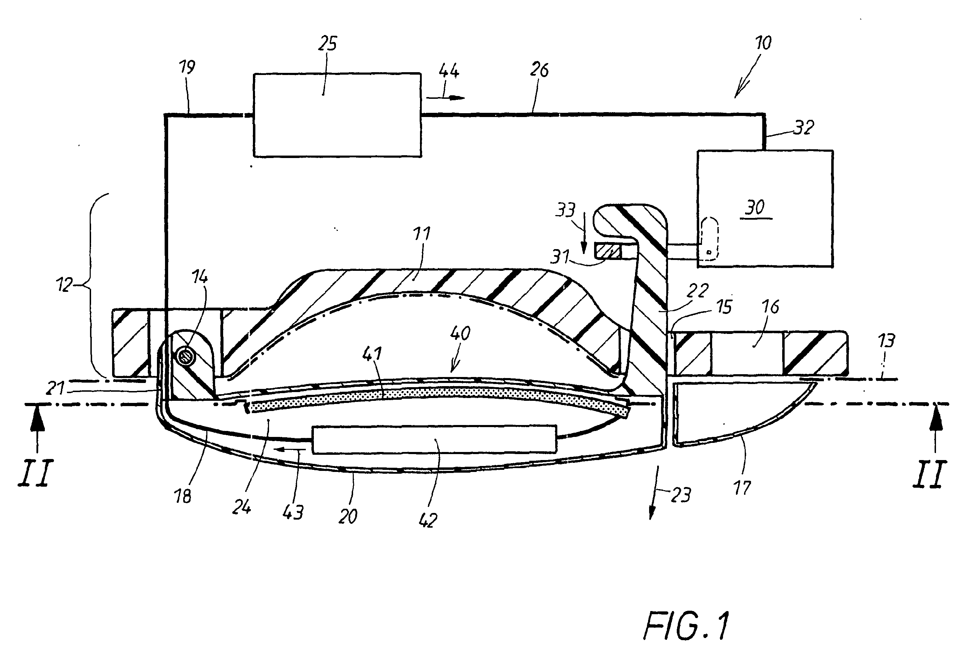

Das Schloss 30 hält die Tür 12 normalerweise in ihrer geschlossenen Position. Das Schloss 30 kann sich wahlweise in einer von zwei Betriebsstellungen befinden, nämlich einer Verriegelungsstellung und einer Entriegelungsstellung. Wird die Handhabe 20 im Sinne des Pfeils 23 von Fig. 1 verschwenkt, so wird über das verlängerte Handhabenende 22 das Schlossglied 31 im Sinne des Mitnahmepfeils 33 von Fig. 1 mitgenommen. Wenn eine Entriegelungsstellung des Schlosses 30 vorliegt, ist diese Betätigung 23 der Handhabe 20 wirksam. Dann gibt das Schloss 30 die Tür frei und die Tür 12 kann geöffnet werden. Liegt dagegen die Verriegelungsstellung des Schlosses 30 vor, so ist die Betätigung 23 unwirksam; das Schlossglied 31 wird im Leerlauf mitgenommen, ohne dass das Schloss 30 die Tür freigibt. Trotz der Betätigung 23 bleibt das Schloss 30 in Verriegelungsstellung in seiner geschlossenen Position.

Die Umsteuerung des Schlosses 30 kann zwar im Notfall mechanisch, z.B. über einen Schließzylinder erfolgen. Das ist zwar nicht näher dargestellt, doch ist ein weiterer Durchbruch 16 im Träger 11 und in der Türaußenverkleidung zu erkennen, in welchem ein solcher Schließzylinder angeordnet sein könnte. Der Schließzylinder ist über einen Notschlüssel betätigbar. Das Stirnende des Schließzylinders, wo der Schlüssel ein- und aussteckbar ist, kann in einer Abdeckung 17 integriert sein, die am Träger 11 befestigt und bündig neben der Handhabe 20 angeordnet ist. Im Normalfall erfolgt die Umsteuerung des Schlosses 30 zwischen der Entriegelungsstellung und Verriegelungsstellung auf elektrischem Weg. Dazu besitzt das Schloss 30 einen elektrischen Eingang 32. Auslöser für eine solche elektrische Umsteuerung des Schlosses 30 ist ein Sensor 40.

Der Sensor 40 spricht auf eine Annäherung oder Berührung an und ist im vorliegenden Fall im Inneren 24 der Handhabe 20 angeordnet. Der Sensor 40 ist im vorliegenden Fall auf kapazitivem Wege wirksam und umfasst mindestens eine Elektrode 41, die im Handhaben-Inneren 24 angeordnet ist. Dort befinden sich auch wenigstens einige elektronische Bauteile 42 des Sensors, die an einer nicht näher gezeigten Platine sitzen.

Die Elektrode 41 baut zusammen mit anderen Bestandteilen des Fahrzeugs und/oder der Umgebung ein elektrisches Feld auf. Gelangt ein Objekt in dieses elektrische Feld, so ändert sich die Kapazität zwischen der Elektrode 41 und dem Fahrzeug bzw. der Umgebung, was von den elektrischen Bauteilen 42 des Sensors registriert wird. Von den elektrischen Bauteilen gehen Signale aus, die durch den Pfeil 43 in Fig. 1 veranschaulicht sind. Diese Signale 43 werden über elektrische Leitungen 18 im Bereich der Handhabe 20 und über ein sie verlängerndes elektrisches Kabel 19 in der Tür 12 und im Fahrzeug bis zu einem Steuergerät 25 weitergeleitet. Es kann sich dabei um ein zentrales Steuergerät 25 handeln, das über zahlreiche elektrische Verbindungen 26 auf die verschiedenen Schlösser 30 einwirkt, die an den diversen Türen und Klappen des Fahrzeugs vorgesehen sind. Die elektrische Verbindung 26 ist an dem bereits erwähnten elektrischen Eingang 32 des jeweiligen Schlosses 30 angeschlossen. Anstelle einer elektrischen Verbindung 26 könnte das Steuergerät 25 auch mechanisch auf ein zweites, nicht näher gezeigtes Eingangsglied des Schlosses 30 einwirken.

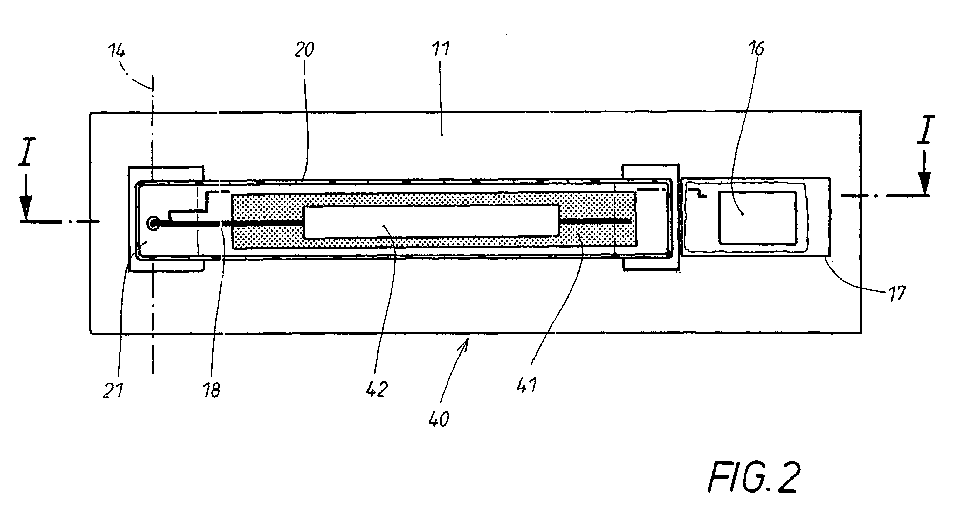

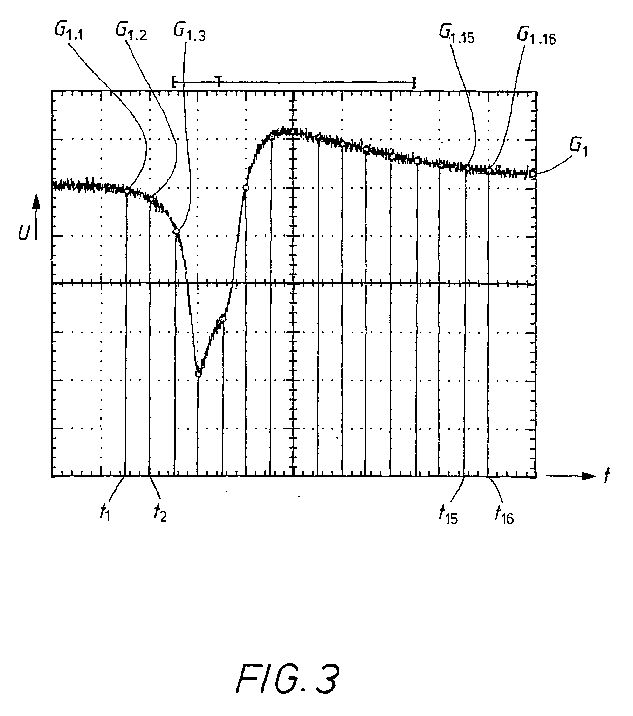

Was im Betätigungsfall passiert, ist anhand der Fig. 3 bis 5 näher erläutert. In Fig. 3 ist der Spannungsverlauf in der elektrischen Schaltung der Bauteile 42 in Abhängigkeit von der Zeit dargestellt, wenn sich die menschliche Hand der Handhabe 20 vom Türaußengriff gemäß Fig. 1 und 2 nähert und ihn kurz betätigt.

Zuerst wird im Zeitpunkt t₁ eine Spannungsänderung festgestellt, nämlich die Spannung G_{1.1}. Von da an beginnt der Sensor in definierten Zeitabständen t₂ bis t₁₆ die Spannungen zu registrieren, woraus sich in diesem weiteren Zeitraum die in Fig. 3 ersichtlichen Werte G_{1.2} bis G_{1.16} ergeben. Die erfindungsgemäße Vorrichtung hat in einer anfänglichen Einstellphase zahlreiche Datensätze aufgenommen und in einem Speicher abgelegt, der zu den elektrischen Bauteilen 42 in der Handhabe 20 gehört. Auch beim Erfassen dieser Datensätze wurde der zeitliche Verlauf des ansprechenden Senders an den gleichen definierten Zeitpunkten t₁ bis t₁₆ erfasst, wobei diese Datensätze bewertet wurden. Dabei gab es auch einen Satz G₁ von betätigungs-typischen Gut-Daten G_{1.1} bis G_{1.16}, der den in Fig. 3 dargestellten Ist-Daten gleich oder zumindest sehr ähnlich ist.

Die elektronischen Bauteile 42 umfassen auch einen nicht näher gezeigten Controller, der die eingehenden Ist-Daten G₁ mit den gespeicherten Datensätzen vergleicht und dabei im angenommenen Fall die Übereinstimmung feststellt. Es gelangt dann ein Signal 43 an das Steuergerät 25, das dann über seine elektrische Verbindung 26 das Schloss 30 freischaltet, wenn noch weitere Bedingungen erfüllt sind.

Eine solche weitere Bedingung für die Freischaltung ergibt sich aus dem Umstand, dass nur berechtigten Personen der Zutritt zum Fahrzeug gewährt werden soll, nicht aber unberechtigten Personen. Die berechtigte Person trägt einen Identifikationsgeber bei sich, der nachfolgend kurz "ID-Geber" bezeichnet werden soll und dem ein entsprechender Identifikationsnehmer im Fahrzeug zugeordnet ist, der analog "ID-Nehmer" genannt werden soll. Normalerweise wirkt ein solcher ID-Geber passiv, einfach durch die Annäherung der berechtigten Person an das Fahrzeug, ohne dass die Person am ID-Geber oder mit dem ID-Geber aktiv werden muss. Es ist aber auch ein aktiver ID-Geber denkbar, wie z.B. ein elektronischer Fernbedienungsschlüssel, der, um wirksam zu werden, durch eine Taste bedient werden muss. In beiden Fällen findet eine mono- oder bilaterale Kommunikation mit dem ID-Nehmer statt. Ist diese Kommunikation erfolgreich, so wird auch dies dem Steuergerät 25 gemeldet, das auch die weitere Bedingung für das Freischalten empfängt und dann über die genannte elektrische oder mechanische Verbindung 26 das Schloss 30 in seine bereits erwähnte Entriegelungsstellung überführt. Wird dann die Handhabe 20 tatsächlich im Sinne des Pfeils 23 von Fig. 1 betätigt, so gibt das Schloss 30 die Tür 12 frei.

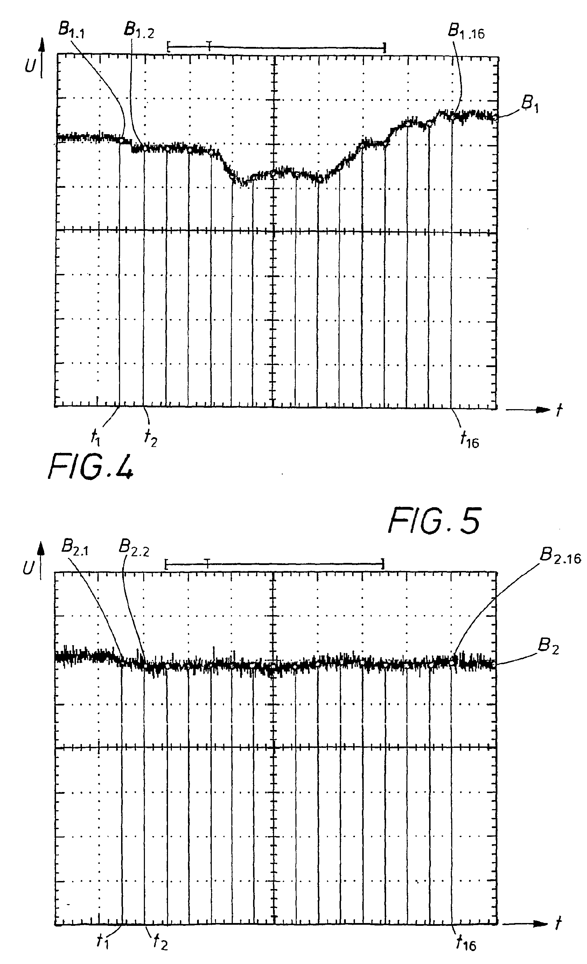

Wie bereits erwähnt wurde, kann der Speicher des erfindungsgemäßen Sensors außer dem Satz G₁ von Gut-Daten noch zahlreiche andere Datensätze aufweisen, die überprüft werden, bevor die Auswertung durch die elektronischen Bauteile 42 ein Freischalt-Signal 43 dem Steuergerät 25 zuleitet. Dazu können auch Sätze B₁ und B₂ von Daten gehören, deren zeitlicher Verlauf in den Fig. 4 und 5 erläutert ist.

In Fig. 4 ist ein Kurvenverlauf B₁ dargestellt, der sich ergibt, wenn ein Wasserschwall auf die Handhabe 20 fällt. Das passiert, wenn das Fahrzeug in starkem Regen steht. Auch hier findet bei t₁ eine erste signifikante Änderung der erfassten Werte mit B_{1.1} statt. Von da ab wird zu den weiteren Zeitpunkten t₂, t₃ usw. die Spannungswerte B_{1.2} usw. bis B_{1.16} registriert. Eine solche Datenregistrierung der B₁-Datensätze ist in der bereits erwähnten anfänglichen Einstellphase im Speicher des Sensors eingegeben worden und steht nun auch während der späteren Gebrauchsphase des Türaußengriffs zur Verfügung. Wenn dann bei Gebrauch ein starker Regen gemäß Fig. 4 fällt, wird an den definierten zeitlichen Stellen im Kurvenverlauf der Datensatz B₁ erfasst, der vom Controller mit den bereits gespeicherten weiteren Datensätzen verglichen wird. Wird dann eine signifikante Übereinstimmung mit bereits gespeicherten, fehlertypischen "Schlecht-Daten" festgestellt, so wird vom Steuergerät 25 das Schloss 30 nicht freigeschaltet. War das Schloss vorausgehend in seiner Verriegelungsstellung, so bleibt die Betätigung 23 der Handhabe 20 unwirksam, wie bereits oben beschrieben wurde.

Die Fig. 5 zeigt einen weiteren Satz B₂ von "Schlecht-Daten", die sich dann ergeben, wenn Wasserspritzer die Handhabe treffen. Auch die Schlscht-Daten B_{2.1} bis B_{2.16} sind im Speicher des erfindungsgemäßen Türaußengriffs erfasst und stehen der Auswertung durch den Controller in der späteren Gebrauchsphase zur Verfügung. Stellt der Controller eine identische oder ähnliche Übereinstimmung von Ist-Daten mit dem Datensatz B₂ fest, so erfolgt keine Freischaltung; das Schloss 30 bleibt in seiner Verriegelungsstellung.

Die erfindungsgemäße Vorrichtung ist nicht nur auf eine Schließeinrichtung, sondern auch auf andere elektrische oder elektromechanische Einrichtungen auf Fahrzeugen anwendbar. Eine weitere Möglichkeit besteht z.B. in einem sogenannten Start-Stopp-Schalter für den Motor des Fahrzeugs. Auch ein solcher Schalter umfasst eine Handhabe, die bei ihrer Betätigung aus einer Ausgangslage in wenigstens eine weitere Betriebslage überführbar ist, wenn es sich um eine bewusste Betätigung einer berechtigten Person handelt. Erfolgt die Betätigung des Schalters durch Objekte, die nicht eine menschliche Hand sind, so wird dies auch von dieser Vorrichtung erkannt und es erfolgt dann kein Freischalten. Trotz eventueller Betätigung, die dann noch möglich sein könnte, wird der Motor nicht zwischen seinen verschiedenen Betriebszuständen umgesteuert.

Außer dem beschriebenen kapazitiven Sensor könnten auch Sensoren anderer, an sich bekannter Art verwendet werden. Eine Möglichkeit ist es, einen optischen Sensor einzusetzen. Eine weitere Möglichkeit ist es, elektromagnetisch betätigbare Sensoren zu verwenden, z.B. über Radar wirksame Sensoren.

Es kommt auf eine möglichst schnelle Reaktion der erfindungsgemäßen Vorrichtung an. In diesem Fall empfiehlt es sich, dass der Controller die Betätigung der Einrichtung bereits mit dem Signal "Beginn" freizuschalten beginnt, ohne aber die Betätigung tatsächlich zuzulassen. Stellt der Controller bei der weiteren Auswertung einen negativen Vergleich fest, nämlich dahingehend, dass die Ist-Daten zu einem Schlecht-Datensatz gehören, dann widerruft der Controller die Freischaltung. Dies erfolgt so rechtzeitig, dass die tatsächliche Betätigung der Einrichtung auch in diesem Fall unwirksam bleibt.

Normalerweise werden bereits herstellerseitig die diversen Gut-Daten und/oder die Schlecht-Datensätze in den Speicher eingegeben und stehen während der Gebrauchsphase dem Fahrzeugkäufer zur Verfügung. Man könnte die Vorrichtung aber auch lernfähig machen. Dazu genügt es die Einstellphase auch während des späteren Gebrauchs der Vorrichtung ablaufen zu lassen. Die Vorrichtung kann nämlich nach folgendem Kriterium identifizieren, ob aktuell eingehende Ist-Daten als Schlecht-Daten oder als Gut-Daten zu interpretieren sind.

Erfolgt nämlich nach dem Eingang von Ist-Daten keine konkrete Betätigung der Einrichtung, so kann die Vorrichtung diesen Datensatz als Schlecht-Daten aufweisen. Umgekehrt, wird nach dem Eingang der Ist-Daten eine Betätigung ausgeführt, dann kann die Vorrichtung feststellen, dass es sich um Gut-Daten handelt. Diese Daten kann die Vorrichtung in den Speicher mit aufnehmen und dadurch ihre Kompetenz für künftige Anwendungsfälle vergrößern.

### Bezugszeichenliste:

- 10: Einrichtung, Schließeinrichtung
- 11: Träger
- 12: Tür
- 13: Außenverkleidung von 12
- 14: Schwenklager von 20 an 11
- 15: Durchbruch in 11 für 22
- 16: Durchbruch in 11 für Schließzylinder
- 17: Abdeckung von 11
- 18: elektrische Leitung für 43 in 20
- 19: elektrisches Kabel für 43
- 20: Handhabe
- 21: erstes Ende von 20
- 22: zweites Ende von 20
- 23: Pfeil der Schwenkbewegung von 20, Betätigung
- 24: Inneres von 20
- 25: Steuergerät
- 26: elektrische Verbindung

- 30: Schloss
- 31: mechanisches Eingangsglied von 30, Schlossglied
- 32: elektrischer Eingang von 30
- 33: Pfeil der Mitnahmebewegung von 31

- 40: Sensor, kapazitiver Sensor
- 41: Elektrode von 40
- 42: elektrische Bauteile von 40
- 43: Pfeil eines elektrischen Signals von 42, Freischalt-Signal
- 44: Freischaltungs-Signal von 25 für 32

- B₁: erster Satz von Schlecht-Daten (Fig. 4)
- B_{1.1}-B_{1.16}: Daten von B₁
- B₂: zweiter Satz von Schlecht-Daten (Fig. 5)
- B_{2.1}-B_{2.16}: Daten von B₂
- G₁: Satz von Gut-Daten (Fig. 3)
- G_{1.1}-G_{1.16}: Daten von G₁

- t₁: erster Zeitpunkt einer signifikanten Signaländerung in G₁, B₁ bzw. B₂
- t₂ - t₁₆: weitere definierte Zeitpunkte von G₁, B₁ bzw. B₂

## Patentansprüche

1. Vorrichtung zum Betätigen von elektrischen oder elektromechanischen Einrichtungen (10) an oder in einem Fahrzeug,
mit mindestens einem Sensor (40), der auf Annäherung oder Berührung anspricht,
mit einem Speicher für Soll-Daten und mit einem Controller, der die eingehenden Ist-Daten mit den Soll-Daten vergleicht und bei erfolgreichem Vergleich die Betätigung (23) der Einrichtung (10) freischaltet,
dass in einer Einstellphase der Vorrichtung mindestens ein Datensatz (G₁, B₁, B₂) jener Signale (G_{1.1} bis G_{1.6}; B_{1.1} bis B_{1.16}; B_{2.1} bis B_{2.16}) erfasst und im Speicher abgelegt wird,
die im zeitlichen Signal-Verlauf des ansprechenden Sensors (40) an wenigstens einigen definierten Zeitpunkten (t₁ bis t₁₆) anfallen,
nämlich ein Satz (G₁) von betätigungs-typischen Gut-Daten (G_{1.1} bis G_{1.16}) und/oder ein Satz (B₁; B₂) von fehler-typischen Schlecht-Daten (B_{1.1} bis B_{1.16}; B_{2.1} bis B_{2.16}),
dass während der späteren Gebrauchsphase der Vorrichtung bei ansprechendem Sensor (40) ein Ist-Datensatz analoger Signale im zeitlichen Signal-Verlauf in den gleichen definierten Zeitpunkten (t₁ bis t₁₆) wie in der Einstellphase erfasst wird,
dass dieser Ist-Datensatz vom Controller wenigstens mit einem der gespeicherten Datensätze (G₁; B₁; B₂) verglichen wird
**dadurch gekennzeichnet,**
**dass** die Betätigung der Einrichtung vom Controller nur dann frei geschaltet (44) wird, wenn der Ist-Datensatz mit dem Gut-Datensatz (G₁) übereinstimmt und nicht Inhalt des Schlecht-Datensatzes (B₁; B₂) ist.

2. Vorrichtung nach Anspruch 1, **dadurch gekennzeichnet, dass** der Speicher eine Vielzahl von Sätzen mit Gut-Daten (G₁) aufnimmt.

3. Vorrichtung nach Anspruch 1 oder 2, **dadurch gekennzeichnet, dass** der Speicher eine Vielzahl von Sätzen mit Schlecht-Daten (B₁, B₂) aufnimmt.

4. Vorrichtung nach einem der Ansprüche 1 bis 3, **dadurch gekennzeichnet, dass** bei der Auswertung der Controller alle Sätze mit Gut-Daten (G₁) überprüft und erst dann entscheidet, ob eine Übereinstimmung oder eine Nicht-Übereinstimmung mit dem Ist-Datensatz vorliegt.

5. Vorrichtung nach einem der Ansprüche 1 bis 4, **dadurch gekennzeichnet, dass** der bei der Auswertung der Controller alle Sätze mit Schlecht-Daten (B₁, B₂) überprüft und erst dann entscheidet, ob eine Übereinstimmung oder eine Nicht-Übereinstimmung mit dem Ist-Datensatz vorliegt.

6. Vorrichtung nach einem der Ansprüche 1 bis 5, **dadurch gekennzeichnet, dass** die Einrichtung eine Schließeinrichtung (10) für Türen (12) oder Klappen des Fahrzeugs ist
und dass nach dem Freischalten (44) die Schließeinrichtung (10) bei Betätigung (23) die Tür (12) oder Klappe öffnet oder schließt.

7. Vorrichtung nach Anspruch 6, **dadurch gekennzeichnet, dass** die Schließeinrichtung (10) eine Handhabe (20) aufweist, die zur Betätigung (23) der Schließeinrichtung (23) im Öffnungssinne oder im Schließsinne dient,
und dass wenigstens einige Bauteile (42) der Vorrichtung in der Handhabe (20) integriert sind.

8. Vorrichtung nach einem der Ansprüche 1 bis 7, **dadurch gekennzeichnet, dass** die Einrichtung ein Start-Stopp-Schalter für den Motor des Fahrzeugs ist
und dass nach dem Freischalten bei Betätigung der Start-Stopp-Schalter den Motor zwischen verschiedenen Betriebszuständen umsteuert.

9. Vorrichtung nach einem der Ansprüche 1 bis 8, **dadurch gekennzeichnet, dass** der Sensor (40) kapazitiv wirksam ist.

10. Vorrichtung nach einem der Ansprüche 1 bis 8, **dadurch gekennzeichnet, dass** der Sensor optisch wirksam ist.

11. Vorrichtung nach einem der Ansprüche 1 bis 8, **dadurch gekennzeichnet, dass** der Sensor elektromagnetisch oder über Radar wirksam ist.

12. Vorrichtung nach einem der Ansprüche 1 bis 11, **dadurch gekennzeichnet, dass** der Controller bereits mit dem Signalbeginn (G_{1.1}; B_{1.1}; B_{2.1}) des Ist-Datensatzes die Betätigung (23) der Einrichtung (10) frei zu schalten (44) beginnt, aber die Betätigung (23) noch nicht zulässt,
und dass der Controller bei negativem Vergleich nach Auswertung des angefallenen Ist-Datensatzes das Freischalten (44) der Betätigung (23) widerruft und die Betätigung unwirksam setzt.

13. Vorrichtung nach einem oder mehreren der Ansprüche 1 bis 12, **dadurch gekennzeichnet, dass** eine berechtigte Person einen aktiven oder passiven Identifikationsgeber (ID-Geber) bei sich hat,
dass der ID-Geber mit einem Identifikationsnehmer (ID-Nehmer) im Fahrzeug kommuniziert
und dass bei erfolgreicher Kommunikation zwischen dem ID-Geber und dem ID-Nehmer die Betätigung (23) der Einrichtung (10) freigeschaltet (44) wird.

14. Vorrichtung nach Anspruch 13, **dadurch gekennzeichnet, dass** der Controller bereits mit dem Signalbeginn (G_{1.1}; B_{1.1}; B_{2.1}) des Ist-Datensatzes die Betätigung (23) der Einrichtung (10) wirksam frei zu schalten beginnt, aber die Betätigung (23) noch nicht zulässt,
und dass bei erfolgloser Kommunikation zwischen dem ID-Geber und dem ID-Nehmer das Freischalten (44) der Betätigung (23) widerrufen und die Betätigung (23) unwirksam setzt.

15. Vorrichtung nach einem oder Ansprüche 1 bis 14, **dadurch gekennzeichnet, dass** die Einstellphase auch während des späteren Gebrauchs der Vorrichtung abläuft,
dass die Vorrichtung auch in der Gebrauchsphase lernt und aktuelle Ist-Daten nach folgendem Kriterium identifiziert und wenigstens einige davon speichert,
wobei eingehende Ist-Daten, denen keine konkrete Betätigung (23) der Einrichtung (10) folgt, als Schlecht-Daten (B₁; B₂) interpretiert werden,
während Ist-Daten als Gut-Daten (G₁) erkannt werden, wenn sich nach ihrem Eingang eine Betätigung (23) der Einrichtung (10) anschließt.

## Claims

1. Device for operating electrical or electromechanical devices (10) on or in a vehicle,
with at least one sensor (40) that is activated by approach or contact,
with a memory for set data and with a controller that compares the incoming actual data with the set data and if the comparison is successful enables the operation (23) of the device (10),
that in the setting phase of the device acquires at least one data record (G₁, B₁, B₂) of those signals (G_{1.1} to G_{1.6}; B_{1.1}, to B_{1.16}; B_{2.1} to B_{2.16}),
that occurs in the time signal characteristic of the responding sensor (40) at at least some defined time points (t₁ to t₁₆) and stores it in the memory,
i.e. a record (G₁) of operation-typical good data (G_{1.1}, to G_{1.16}) and/or a record (B₁; B₂) of fault-typical bad data (B_{1.1} to B_{1.16}; B_{2.1} to B_{2.16})
that during the subsequent usage phase of the device, when a sensor (40) responds an actual data record of analogue signals in the time signal characteristic in the same defined time points (t₁ to t₁₆) as in the setting phase is acquired,
that this actual data record is compared by the controller with at least one of the saved data records (G₁; B₁; B₂),
**characterized in that**
the operation of the device by the controller is only enabled (44) if the actual data record agrees with the good data record (G₁) and not the content of the bad data record (B₁; B₂)'

2. Device according to Claim 1, **characterized in that** the memory holds a number of records with good data (G₁).

3. Device according to Claim 1 or 2, **characterized in that** the memory holds a number of records with bad data (B₁, B₂).

4. Device according to one of Claims 1 to 3, **characterized in that** during the evaluation by the controller all records with good data (G₁) are checked and only then is a decision made as to whether there is agreement or non-agreement with the actual data record.

5. Device according to one of Claims 1 to 4, **characterized in that** during the evaluation by the controller all records with bad data (B₁, B₂) are checked and only then is a decision made as to whether there is an agreement or a non-agreement with the actual data record.

6. Device according to one of Claims 1 to 5, **characterized in that** the device has a closing device (10) for doors (12), hoods or the like of the vehicle
and that, after the enabling (44), the closing device (10) when operated (23) opens or closes the door (12), hood or the like.

7. Device according to Claim 6, **characterized in that** the closure device (10) has a handle (20) that serves to operate (23) the closure device (10) in the opening or closing sense,
and that at least some components (42) of the device are integrated into the handle (20).

8. Device according to one of Claims 1 to 7, **characterized in that** the device is a start-stop switch for the engine of the vehicle
and that, after enabling, the engine is switched between two different operating states by operation of the start-stop switch.

9. Device according to one of Claims 1 to 8, **characterized in that** the sensor (40) is capacitatively effective.

10. Device according to one of Claims 1 to 8, **characterized in that** the sensor is optically effective.

11. Device according to one Claims 1 to 8, **characterized in that** the sensor is electromagnetically effective or operated by radar.

12. Device according to one of Claims 1 to 11, **characterized in that** the controller at the start of the signal (G_{1.1}; B_{1.1}; B_{2.1}) of the actual data record starts the operation (23) to enable (44) the device (10) but does not yet permit the operation (23),
and that the controller withdraws the enabling (44) of the operation (23) and renders the operation inoperative if the comparison after evaluation of the occurred actual data record is negative.

13. Device according to one or more of Claims 1 to 12, **characterized in that** an unauthorized person has an active or passive identification transmitter (ID transmitter) on his person,
that the ID transmitter communicates with an identification receiver (ID receiver) in the vehicle
and that if the communication between the ID transmitter and the ID receiver is successful the operation (23) of the device (10) is enabled (44).

14. The device according to Claim 13, **characterized in that** the controller begins effectively to enable the operation (23) of the device (10) on the signal start (G_{1.1}; B_{1.1}; B_{2.1}) of the actual data record but still does not permit the operation (23),
and that if the communication between the ID transmitter and ID receiver is unsuccessful, the enabling (44) of the operation (23) is withdrawn and the operation (23) is rendered inoperative.

15. Device according to one of Claims 1 to 14, **characterized in that** the setting phase also runs during the subsequent use of the device,
that the device also learns and identifies current actual data according to the following criterion in the usage phase and saves at least some of said data,
with incoming actual data which is not followed by any concrete operation (23) of the device (10) being interpreted as bad data (B₁; B₂),
with actual data being identified as good data (G₁) if an operation (23) of the device (10) follows its input.

## Revendications

1. Dispositif pour actionner des équipements (10) électriques ou électromécaniques sur ou dans un véhicule,
comprenant au moins un capteur (40) réagissant par proximité ou effleurement,
avec une mémoire contenant les données de consigne et avec un circuit de contrôle comparant les données réelles entrantes avec les données de consigne et qui, si la comparaison a réussi, débloque l'actionnement (23) de l'équipement (10),
sachant que, dans une phase de réglage du dispositif, la saisie d'au moins un jeu de données (G₁, B₁, B₂) des signaux (G_{1.1} à G_{1.6} ; B_{1.1} à B_{1.6} ; G_{2.1} à G_{2.6}) et sa déposition en mémoire ont lieu,
signaux qui sont présents, à au moins quelques instants définis (t₁ à t₁₆), sur la courbe temporelle des signaux du capteur correspondant (40),
à savoir un jeu (G₁) de données Bonnes typiques de l'actionnement (G_{1.1} à G_{1.16)} et/ou un jeu (B₁; B₂) de données Mauvaises typiques des erreurs (B_{1.1} à B_{1.16} ; B_{2.1} à B_{2.16}),
et que pendant la phase d'utilisation ultérieure du dispositif, lorsque le capteur (40) réagit, un jeu de données réelles (signaux analogiques) est saisi sur la courbe temporelle du signal aux même instants définis (t₁ à t₁₆) que pendant la phase de réglage,
et que le contrôleur compare ce jeu de données réelles au moins avec l'un des jeux de données (G₁ ; B₁ ; B₂) déjà en mémoire,
**caractérisé en ce que**
l'actionnement de l'équipement n'est débloqué (44) par le contrôleur que si le jeu de données réelles concorde avec le jeu de données Bonnes (G₁) et ne représente pas le contenu du jeu de données Mauvaises (B₁ ; B₂).

2. Dispositif selon la revendication 1, **caractérisé en ce que** la mémoire enregistre un grand nombre de jeux de données Bonnes (G₁).

3. Dispositif selon la revendication 1 ou 2, **caractérisé en ce que** la mémoire enregistre un grand nombre de jeux de données Mauvaises (B₁, B₂).

4. Dispositif selon l'une des revendications 1 à 3, **caractérisé en ce que** lors de l'analyse, le contrôleur vérifie tous les jeux de données Bonnes (G₁) et qu'ensuite seulement il décide s'il y a concordance ou non-concordance avec le jeu de données réelles.

5. Dispositif selon l'une des revendications 1 à 4, **caractérisé en ce que** lors de l'analyse, le contrôleur vérifie tous les jeux contenant des données Mauvaises (B₁, B₂) et qu'ensuite seulement il décide s'il y a concordance ou non concordance avec le jeu de données réelles.

6. Dispositif selon l'une des revendications 1 à 5, **caractérisé en ce que** l'équipement est un équipement d'ouverture/fermeture (10) pour portes (12) ou hayons du véhicule,
et **en ce qu'**après le déblocage (44), l'équipement d'ouverture/fermeture (10) ouvre ou ferme la porte (12) ou le hayon en cas d'actionnement (23).

7. Dispositif selon la revendication 6, **caractérisé en ce que** l'équipement d'ouverture/fermeture (10) présente une manette (20) servant à actionner (23) l'équipement (10) dans le sens de l'ouverture ou dans celui de la fermeture,
et **en ce qu'**au moins quelques composants (42) du dispositif sont intégrés dans la manette (20).

8. Dispositif selon l'une des revendications 1 à 7, **caractérisé en ce que** l'équipement est un interrupteur Marche / Arrêt affecté au moteur du véhicule
et **en ce qu'**après le déblocage donné en cas d'actionnement, l'interrupteur Marche / Arrêt commute le moteur sur différents états de service.

9. Dispositif selon l'une des revendications 1 à 8, **caractérisé en ce que** le capteur (40) agit par effet capacitif.

10. Dispositif selon l'une des revendications 1 à 8, **caractérisé en ce que** le capteur agit par effet optique.

11. Dispositif selon l'une des revendications 1 à 8, **caractérisé en ce que** le capteur agit par effet électromagnétique ou effet radar.

12. Dispositif selon l'une des revendications 1 à 11, **caractérisé en ce que** le contrôleur commence à débloquer (44) l'actionnement (23) de l'équipement (10) dès le commencement du signal (G_{1.1}; B_{1.1}; B_{2.1}) contenant le jeu de données Bonnes, mais qu'il n'autorise pas encore cet actionnement (23),
et **en ce que** le contrôleur révoque le déblocage (44) de l'actionnement (23) et rend ce dernier inopérant si après analyse du jeu de données généré le résultat de la comparaison est négatif.

13. Dispositif selon l'une ou plusieurs des revendications 1 à 12, **caractérisé en ce qu'**une personne autorisée porte sur elle un transmetteur d'identification actif ou passif (transmetteur d'ID),
**en ce que** le transmetteur d'ID communique avec un récepteur d'identification (récepteur d'ID) situé dans le véhicule
et **en ce que**, si la communication a réussi entre le transmetteur d'ID et le récepteur d'ID, le contrôleur débloque (44) l'actionnement (23) de l'équipement (10).

14. Dispositif selon la revendication 13, **caractérisé en ce que** le contrôleur commence à débloquer l'actionnement (23) de l'équipement (10) dès le commencement du signal (G_{1.1} ; B_{1.1} ; B_{2.1}) contenant le jeu de données réelles, mais qu'il n'autorise pas encore cet actionnement (23),
et **en ce que** si la communication échoue entre le transmetteur d'ID et le récepteur d'ID, le contrôleur révoque le déblocage (44) de l'actionnement (23) et rend l'actionnement (23) inopérant.

15. Dispositif selon l'une des revendications 1 à 14, **caractérisé en ce que** la phase de réglage se déroule aussi pendant l'utilisation ultérieure du dispositif,
**en ce que** le dispositif apprend aussi pendant la phase d'utilisation, qu'il identifie les données réelles actuelles selon le critère suivant et en mémorise au moins quelques unes, sachant que les données réelles entrantes non suivies par un actionnement concret (23) de l'équipement (10) sont interprétées comme des données Mauvaises (B₁ ; B₂),
tandis que les données réelles sont interprétées comme des données Bonnes (G₁) lorsqu'elle sont suivie, après leur réception, d'un actionnement (23) de l'équipement (10).
